# EUROPÄISCHE PATENTANMELDUNG

(11) **EP 4 819 412 A1**
(43) Veröffentlichungstag der Anmeldung: **07.10.2026**
(21) Anmeldenummer: 26166259.7
(22) Anmeldetag: 20.03.2026
(51) Int. Cl.: H01R 33/20, H01R 25/14

(54) **ELEKTRONISCHE VERSORGUNGSEINRICHTUNG ZUM ELEKTRISCHEN ANSCHLIESSEN EINES ELEKTRISCHEN VERBRAUCHERS UND ELEKTRONISCHE VERBRAUCHEREINRICHTUNG**

(30) Priorität: 20.03.2025 AT 501902025
(71) Anmelder: H4X e.U., 8055 Graz (AT)
(72) Erfinder: HIERZER, Andreas, 8010 Graz (AT)
(74) Vertreter: Isarpatent

(57) **Zusammenfassung**

Eine elektronische Versorgungseinrichtung (100) zum elektrischen Anschließen eines elektrischen Verbrauchers (200), umfasst ein Gehäuse (1) mit einer Befestigungseinrichtung und einer elektrischen Platineneinrichtung (4), wobei das Gehäuse (1) mittels der Befestigungseinrichtung an einer Oberfläche einer externen elektrischen Leitereinrichtung (3) oder an einer eine externe elektrische Leitereinrichtung überdeckenden Oberfläche in einer Kontaktstellung des Gehäuses mechanisch montierbar ist und die elektrische Platineneinrichtung (4) mittels einer Leiterkontakteinrichtung (5), welche beweglich im und/oder mit dem Gehäuse (1) angeordnet ist, in der Kontaktstellung elektrisch an der externen elektrischen Leitereinrichtung (3) anschließbar ist, wobei die elektrische Platineneinrichtung (4) zumindest einen Platinenwiderstand (R2, R3) umfasst; eine elektrische Außenkontakteinrichtung (6), welche an dem Gehäuse (1) angeordnet ist und welche von Gegenkontakten des elektrischen Verbrauchers (200) kontaktierbar ist, wobei die elektrische Außenkontakteinrichtung (6) weiterhin umfasst: einen ersten Außenkontakt (6a), welcher mit einem ersten Gegenkontakt (GK1) des elektrischen Verbrauchers (200) elektrisch kontaktierbar ist; einen zweiten Außenkontakt (6b), welcher mit einem zweiten Gegenkontakt (GK2) des elektrischen Verbrauchers (200) elektrisch kontaktierbar ist; und einen dritten Außenkontakt (6c), welcher mit einem dritten Gegenkontakt (GK3) des elektrischen Verbrauchers (200) elektrisch kontaktierbar ist, wobei der dritte Gegenkontakt (GK3) mit einem vorbestimmten Verbraucherwiderstand (R1) des elektrischen Verbrauchers (200) in elektrischer Verbindung steht, wobei in der Kontaktstellung der vorbestimmte Verbraucherwiderstand (R1) mit dem zumindest einen Platinenwiderstand (R2, R3) einen Spannungsteiler bildet, durch welchen dem elektrischen Verbraucher (200) über den ersten Gegenkontakt (GK1) und über den zweiten Gegenkontakt (GK2) eine für den jeweiligen elektrischen Verbraucher (200) spezifische elektrische Leistung bereitstellbar ist.

## Beschreibung

### TECHNISCHES GEBIET DER ERFINDUNG

Die Erfindung betrifft eine elektronische Versorgungseinrichtung zum elektrischen Anschließen eines elektrischen Verbrauchers und eine elektronische Verbrauchereinrichtung.

### TECHNISCHER HINTERGRUND

Bei üblichen Leuchtensystemen oder Verbrauchern, welche einen Anschluss an eine stationäre Stromquelle benötigen, ist meist die Position der Kontaktführung oder der Anschlüsse der Stromquelle auf eine bestimmte Stelle und einen bestimmten Verbraucher festgelegt und somit beschränkt. Üblicherweise wird eine Verkabelung bis zu einer Kontakt- oder Montageposition des Verbrauchers oder der Leuchte geführt, wobei die Verbindung zwischen Kabel und Kontaktstelle, falls überhaupt, nur wenige Freiheitsgrade der Bewegung oder Positionsvariation erlaubt. Die Position der Kontaktstelle ist somit meist durch die Bauart des Leuchtensystems oder des Verbrauchers auf eine bestimmte Stelle oder einen bestimmten Bereich vorgegeben.

Hinsichtlich einer höheren Flexibilität der Positionierung der elektrischen Kontaktstelle und vorzugsweise auch der Montageposition des Verbrauchers oder Leuchtensystems erscheint es daher wünschenswert, eine elektronische Versorgungseinrichtung zum elektrischen Anschließen eines elektrischen Verbrauchers und eine elektronische Verbrauchereinrichtung bereitzustellen, welche sich durch eine verbesserte und flexiblere Schnittstelle zwischen elektrischem Leiter und dem elektrischen Verbraucher auszeichnet, insbesondere durch deren flexiblere und frei wählbare Positionierungsmöglichkeit an einer Montageoberfläche des elektrischen Leiters.

Die Druckschrift WO 2023/016661 A1 beschreibt einen Stromadapter zum Anschließen eines Verbrauchers an einen elektrischen Leiter.

### ZUSAMMENFASSUNG DER ERFINDUNG

Eine der Aufgaben der Erfindung besteht darin, Lösungen für eine elektronische Versorgungseinrichtung zum elektrischen Anschließen eines elektrischen Verbrauchers zu finden, durch welche eine Kontakt- und Montageposition an einer Oberfläche einer elektrischen Leitereinrichtung flexibel und frei wählbar sein kann und durch welche ein elektrisches Anschließen verschiedener Verbrauchertypen ermöglicht sein kann.

Diese und andere Aufgaben werden durch eine elektronische Versorgungseinrichtung zum elektrischen Anschließen eines elektrischen Verbrauchers mit den Merkmalen des Anspruchs 1 und durch eine elektronische Verbrauchereinrichtung mit den Merkmalen des Anspruchs 17 gelöst.

Gemäß einem ersten Aspekt der Erfindung umfasst die elektronische Versorgungseinrichtung zum elektrischen Anschließen eines elektrischen Verbrauchers ein Gehäuse mit einer Befestigungseinrichtung und einer elektri-schen Platineneinrichtung, wobei das Gehäuse mittels der Befesti-gungseinrichtung an einer Oberfläche einer externen elektrischen Leitereinrichtung oder an einer eine externe elektrische Leitereinrichtung überdeckenden Oberfläche in einer Kontaktstellung des Gehäuses mechanisch montierbar ist und die elektrische Platineneinrichtung mittels einer Leiterkontakteinrichtung, welche beweglich im und/oder mit dem Gehäuse angeordnet ist, in der Kontaktstellung elektrisch an der externen elektrischen Leitereinrichtung anschließbar ist, wobei die elektrische Platineneinrichtung zumindest einen Platinenwiderstand umfasst. Die elektronische Versorgungseinrichtung umfasst weiterhin eine elektrische Außenkontakteinrichtung, welche an dem Gehäuse angeordnet ist und welche von Gegenkontakten des elektrischen Verbrauchers kontaktierbar ist, wobei die elektrische Außenkontakteinrichtung weiterhin einen ersten Außenkontakt umfasst, welcher mit einem ersten Gegenkontakt des elektrischen Verbrauchers elektrisch kontaktierbar ist; einen zweiten Außenkontakt umfasst, welcher mit einem zweiten Gegenkontakt des elektrischen Verbrauchers elektrisch kontaktierbar ist; und einen dritten Außenkontakt umfasst, welcher mit einem dritten Gegenkontakt des elektrischen Verbrauchers elektrisch kontaktierbar ist, wobei der dritte Gegenkontakt mit einem vorbestimmten Verbraucherwiderstand des elektrischen Verbrauchers in elektrischer Verbindung steht, wobei in der Kontaktstellung der vorbestimmte Verbraucherwiderstand mit dem zumindest einen Platinenwiderstand einen Spannungsteiler bildet, durch welchen dem elektrischen Verbraucher über den ersten Gegenkontakt und über den zweiten Gegenkontakt eine für den jeweiligen elektrischen Verbraucher spezifische elektrische Leistung bereitstellbar ist.

Durch die elektronische Versorgungseinrichtung kann vorteilhaft eine elektrische Kontaktschnittstelle zwischen externer elektrischer Leitereinrichtung und dem elektrischen Verbraucher verkörpert sein. Dazu kann die elektronische Versorgungseinrichtung elektrisch mit der externen elektrischen Leitereinrichtung verbunden werden und mechanisch an einer Oberfläche der externen elektrischen Leitereinrichtung selbst oder an einer Oberfläche, welche die externe elektrische Leitereinrichtung überdeckt, befestigt werden. Es kann beispielsweise eine Seitenfläche oder Unterseite des Gehäuses der elektronischen Versorgungseinrichtung auf besagter Oberfläche angelehnt sein und mit Befestigungsmitteln das Gehäuse an dieser Oberfläche und/oder an der externen elektrischen Leitereinrichtung fixieren. Dabei können diese Befestigungsmittel auch den elektrischen Kontakt herstellen, und beispielsweise durch besagte Leiterkontakteinrichtung und/oder Befestigungseinrichtung verkörpert sein.

Die elektrische Außenkontakteinrichtung kann an einer Außenseite des Gehäuses der elektronischen Versorgungseinrichtung vorhanden sein, beispielsweise an einer Oberseite des Gehäuses, welche einer Seite des Gehäuses mit der Befestigungseinrichtung, beispielsweise einer Unterseite des Gehäuses, gegenüberliegen kann. Auf diese Weise kann die elektronische Versorgungseinrichtung in einer ersten Richtung den elektrischen und mechanischen Kontakt zur externen elektrischen Leitereinrichtung herstellen und in eine zweite Richtung, welche der ersten Richtung entgegengerichtet sein kann, einen mechanischen und elektrischen Kontakt zum elektrischen Verbraucher herstellen.

Bei den drei Außenkontakten kann es sich um eine Erdung sowie um einen Plus- und Minuskontakt handeln.

Im elektrischen Kontakt mit den Gegenkontakten kann der vorbestimmte Verbraucherwiderstand des elektrischen Verbrauchers einen Spannungsteiler mit dem zumindest einen Platinenwiderstand darstellen. Dies kann folglich für jeden Verbraucher entsprechend anders sein, wobei die gleiche elektronische Versorgungseinrichtung nun für verschiedene Verbraucher genutzt werden kann, ohne dass diese von der externen elektrischen Leitereinrichtung entfernt und gewechselt werden muss. Der Platinenwiderstand kann hierzu vorzugsweise auch mehr als nur einen Widerstand für die Brückenschaltung umfassen. Entsprechend der nun erzielten Wirkung als Spannungsteiler kann der auftretende Leistungsabfall an dem Verbraucher entsprechend dessen spezifischer Leistung angepasst sein, ohne dass die elektronische Versorgungseinrichtung ersetzt werden muss, da durch die entsprechende Spannungsteilung ein Betrieb der elektronischen Komponenten der elektronischen Versorgungseinrichtung weiter erfolgen kann, auch wenn die spezifische Leistung des Verbrauchers sich von Verbraucher zu Verbraucher unterscheidet.

Die Befestigungseinrichtung kann in oder mit dem Gehäuse beweglich sein, insbesondere zwischen einer Kontaktstellung des Gehäuses und einer Transportstellung des Gehäuses (beispielsweise zweiteiliges Gehäuse). Die Transportstellung kann für jeden solchen Fall angebracht und anwendbar sein, wenn das Gehäuse und damit die elektronische Versorgungseinrichtung nicht in mechanischem und elektrischen Kontakt mit der externen elektrischen Leitereinrichtung verbunden ist. Dazu kann die Leiterkontakteinrichtung in der Transportstellung in das Gehäuse teilweise oder vollständig eingefahren sein, wodurch mechanische Kontakte der Leiterkontakteinrichtung mit anderen Gegenständen außerhalb des Gehäuses vermieden werden können oder die Gefahr dazu zumindest signifikant verringert sein kann. Die Leiterkontakteinrichtung kann aber dennoch (in beiden Positionen des Gehäuses) mit der Platineneinrichtung mechanisch und elektrisch verbunden sein. Das Gehäuse kann vorteilhaft einen ersten Teil und einen zweiten Teil umfassen, wobei zum Einnehmen der Kontaktstellung der erste Teil des Gehäuses in den zweiten Teil des eingeschoben werden kann (oder umgekehrt) und dabei die Leiterkontakteinrichtung, beispielsweise Nadeln umfassend, aus Öffnungen an der Unterseite des Gehäuses, welch den Boden des ersten Teils darstellen kann, herausgedrückt werden können. Das Gehäuse kann dann in der Kontaktstellung und mit der ausgefahrenen Leiterkontakteinrichtung durch die Oberfläche der externen elektrischen Leitereinrichtung hindurch gedrückt werden und dadurch die Leiterkontakteinrichtung, beispielsweise die Nadeln, mit dem elektrischen Leiterbahnen der externen elektrischen Leitereinrichtung mechanisch und elektrisch verbunden werden. Um die Haltekraft zwischen dem Gehäuse und der Oberfläche an der externen elektrischen Leitereinrichtung zu verstärken, kann einer oder mehrere Magnete im Gehäuse angeordnet sein, um das Gehäuse an der Oberfläche der externen elektrischen Leitereinrichtung zu halten.

Das Gehäuse kann des Weiteren einen Sicherungsmechanismus aufweisen, welcher in der Transportstellung aus zumindest einem der Teile des Gehäuses radial oder in eine Richtung seitlich lateral (senkrecht zur Verschiebungsrichtung der beiden Teile des Gehäuses ineinander) herausragen kann und ein Ineinanderschieben der beiden Gehäuseteile verhindern kann. Der Sicherungsmechanismus kann einen oder mehrere gefederte Knöpfe umfassen, welche in das Innere des Gehäuseteils, an welchem sie angeordnet sind, gedrückt werden können und dann die beiden Gehäuseteile ineinandergeschoben werden können, da dann der zumindest eine Knopf die Außenränder der beiden Gehäuseteile nicht mehr überragt (lateral) und somit ein Ineinanderschieben nicht mehr verblockt und das Gehäuse in die Kontaktstellung geschoben werden kann.

Gemäß einem ersten Aspekt der Erfindung umfasst die elektronische Verbrauchereinrichtung eine erfindungsgemäße elektronische Versorgungseinrichtung, welche an eine externe elektrische Leitereinrichtung mit einer Oberfläche elektrisch und mechanisch anschließbar ist und die elektronische Verbrauchereinrichtung weiterhin umfassend einen elektrischen Verbraucher, welcher über die elektronische Versorgungseinrichtung elektrisch an die externe elektrische Leitereinrichtung anschließbar und betreibbar ist.

Die elektrische Verbrauchereinrichtung, mit einem Verbraucher, kann vorteilhaft durch die elektronische Versorgungseinrichtung mit einem bestimmten Strom/einer bestimmten Spannung, welche für deren Betrieb notwendig ist, versorgt werden. Durch den Spannungsteiler, welchen die Verbindung des zumindest einen Platinenwiderstandes mit dem Verbraucherwiderstand bei entsprechend kontaktierten Außen- und Gegenkontakten bilden kann, kann dem Verbraucher eine derart zugeschnittene Spannung oder Spannungsintervall angesetzt sein, dass dieser mit einer für ihn vorbestimmten spezifischen Leistung betrieben werden kann.

Vorteilhafte Ausgestaltungen und Weiterbildungen ergeben sich aus den weiteren Unteransprüchen sowie aus der Beschreibung unter Bezugnahme auf die Figuren.

Gemäß einer Weiterbildung der elektronischen Versorgungseinrichtung ist/sind der erste Außenkontakt und/oder der zweite Außenkontakt und/oder der dritte Außenkontakt als Ringkontakt ausgeformt.

Gemäß einer Weiterbildung der elektronischen Versorgungseinrichtung bildet der erste Außenkontakt eine Kreisfläche und der zweite Außenkontakt und der dritte Außenkontakt umlaufen als konzentrische und zueinander beabstandete Ringflächen den ersten Außenkontakt.

Durch eine Ausgestaltung als Ringflächen oder Kreisfläche kann die Kontaktierung über die jeweiligen Gegenkontakte vorteilhaft derart erfolgen, dass eine Verdrehung der Gehäuse der Versorgungseinrichtung und des Verbrauchers um 360° erfolgen kann, und die Kontaktführung des Gegenkontaktes entlang der zugehörigen Ringfläche bzw. Kreisfläche vorteilhaft nicht unterbrochen wird. Die Gegenkontakte können dazu vorteilhaft derart angeordnet sein, dass sie sich bei Gegenüberstellung der beiden Gehäuse der Versorgungseinrichtung und des Verbrauchers mit den zugehörigen Kreis- oder Ringflächen gegenüberliegen und dass bei Einfassung des Gehäuses der Versorgungseinrichtung in die Kontaktausnehmung des Gehäuses des Verbrauchers eine Verdrehung der Gehäuse zueinander nur derart erfolgen kann (die Kontaktausnehmung kann vorteilhaft eine radiale oder laterale Verschiebung der Gehäuse zueinander derart limitieren, dass bei Bewegung und Verdrehung die Gegenkontakte die Flächen der Außenkontakte nicht verlassen und die Bahnen der Bewegung der Gegenkontakte bei Verdrehung der Gehäuse zueinander die Flächen der Außenkontakte nicht vollständig, aber möglicherweise teilweise, verlassen), dass die gegenseitige (mechanische und elektrische) Kontaktierung der Gegenkontakte mit den Außenkontakten aufrechterhalten bleibt. Die Drehung kann beispielsweise um eine Achse herum erfolgen, die durch einen Mittelpunkt der zentralen Kreisfläche des ersten Außenkontaktes verläuft.

Gemäß einer Weiterbildung der elektronischen Versorgungseinrichtung umfasst die Leiterkontakteinrichtung zumindest zwei Nadeln als elektrische Kontakte, welche in der Kontaktstellung des Gehäuses aus diesem ausgefahren sind und mit der Oberfläche der externen elektrischen Leitereinrichtung oder mit der die externe elektrische Leitereinrichtung überdeckenden Oberfläche in mechanischen und elektrischen Kontakt bringbar sind.

Gemäß einer Weiterbildung der elektronischen Versorgungseinrichtung ist mit den Nadeln die Oberfläche der externen elektrischen Leitereinrichtung oder die die externe elektrische Leitereinrichtung überdeckende Oberfläche durchdringbar und dabei sind unterschiedliche Nadeln mit elektrischen Leitern unterschiedlicher Polung kontaktierbar, insbesondere durch die Nadeln.

Gemäß einer Weiterbildung der elektronischen Versorgungseinrichtung ist die elektrische Außenkontakteinrichtung an einer von außen zugänglichen Oberseite des Gehäuses angeordnet, welche einer Unterseite des Gehäuses gegenüberliegt, wobei an der Unterseite die Befestigungseinrichtung angeordnet ist und/oder die Leiterkontakteinrichtung ausfahrbar ist.

Die Leiterkontakteinrichtung kann auch mehr als zwei Nadeln umfassen, beispielsweise fünf. Mit den Nadeln können Leiter der externen Leitereinrichtung mechanisch und elektrisch kontaktiert werden, wobei zumindest zwei Nadeln solche (Teil)Leiter der Leitereinrichtung kontaktieren können, durch welche ein zueinander gegensätzlich gepolter Strom fließt. Durch die spitze Form der Nadeln kann sowohl die Oberfläche an der Leitereinrichtung als auch die Leitereinrichtung selbst durchdrungen oder erreicht werden, wenn das Gehäuse der Versorgungseinrichtung mit einer bestimmten Kraft des Nutzers auf die externe Leitereinrichtung oder auf deren Oberfläche aufgesetzt wird.

Bei der externen Leitereinrichtung kann es sich beispielsweise um eine Wandkomponente und/oder Deckenkomponente für ein Zimmer handeln, welche auf eine Wand und/oder Decke aufgebracht oder in diese integriert sein kann oder die Wand und/oder Decke selbst darstellen kann, wobei die Oberfläche als Putz der Wand und/oder Decke dienen kann und eine bestimmte Farbe aufweisen kann. Letztere kann bei Renovierung des Zimmers auch erneut mit Farbe übermalt werden.

Gemäß einer Weiterbildung der elektronischen Versorgungseinrichtung umfasst die elektronische Versorgungseinrichtung und die Platineneinrichtung zumindest einen Gleichrichter, mit welchem ein über die Leiterkontakteinrichtung von der externen elektrischen Leitereinrichtung aufgenommener Strom auf den ersten Außenkontakt und den zweiten Außenkontakt mit zueinander unterschiedlichen Polungen beaufschlagbar ist. Durch den Gleichrichter kann an die beiden Außenkontakte (erster und zweiter, oder auch gemäß anderer Anordnung) ein Gleichstrom mit einer bestimmten Gleichspannung, beispielsweise 48 V, angelegt sein. Durch den entsprechend vorliegenden Spannungsteiler kann dann der Strom und somit die spezifische Leistung des Verbrauchers erreicht werden.

Gemäß einer Weiterbildung der elektronischen Versorgungseinrichtung ist das Gehäuse mit der Befestigungseinrichtung dazu eingerichtet, an einer ebenen Oberfläche angeordnet zu werden, welche die externe elektrische Leitereinrichtung darstellt oder diese überdeckt.

Gemäß einer Weiterbildung der elektronischen Versorgungseinrichtung umfasst die elektrische Platineneinrichtung zumindest zwei flache Platinen, welche zueinander beabstandet sind und entlang einer Achse zentriert und parallel verlaufen und über eine Kontakteinrichtung oder Steckereinrichtung miteinander verbunden sind.

Aus Gründen der Platzeinsparung können zwei, oder auch mehrere, Platinen miteinander durch Stecker verbunden sein und parallel zueinander im Gehäuse der Versorgungseinrichtung angeordnet werden. Dabei kann es auch möglich sein, solche Bauteile, welche eine erhöhte Hitzeentwicklung aufweisen, auf einer anderen Platine anzuordnen, als Bauteile, welche eine starke Hitzeempfindlichkeit aufweisen.

Gemäß einer Weiterbildung der elektronischen Versorgungseinrichtung sind die drei Außenkontakte an einer der ersten Platine abgewandten Seite der zweiten Platine angeordnet.

Die Außenkontakte können an der zweiten Platine angeordnet sein, und im zusammengesteckten Zustand der beiden Platinen von der ersten Platine abgewandt sein. Des Weiteren können sich die Außenkontakte auch aus dem Gehäuse heraus erstrecken oder zumindest in einer Ausnehmung des Gehäuses liegen und von einer Außenseite/Umgebung zugänglich sein (freiliegen).

Gemäß einer Weiterbildung der elektronischen Versorgungseinrichtung umfasst die elektrische Platineneinrichtung eine Steuereinrichtung, mit welcher ein drahtlos übermitteltes Steuerungssignal empfangbar und interpretierbar ist und über welche ein Betrieb des elektrischen Verbrauchers steuerbar ist.

Auf diese Weise kann eine Leistung des Verbrauchers oder dessen zu beaufschlagender Strom gesteuert oder ausgeschaltet werden, beispielsweise kann der Verbraucher als Leuchte gedimmt werden, die Abstrahlfarbe angepasst werden oder ähnliches.

Gemäß einer Weiterbildung der elektronischen Versorgungseinrichtung umfasst der Platinenwiderstand einen ersten Widerstand und einen zweiten Widerstand, welche in Kontaktstellung mit dem vorbestimmten Verbraucherwiderstand einen Spannungsteiler bilden.

Der Spannungsteiler kann als eine Brückenschaltung oder in anderer Form gestaltet sein, wenn der Verbraucherwiderstand mit der Platine über die Außenkontakte verbunden wird.

Gemäß einer Weiterbildung der elektronischen Versorgungseinrichtung ist der Gleichrichter an einer der zweiten Platine zugewandten Seite der ersten Platine angeordnet.

Um den benötigten Platz bei der Bauanordnung innerhalb des Gehäuses zu verringern, kann bereits der Zwischenbereich der beiden Platinen genutzt werden, um das Bauteil des Gleichrichters auszunehmen.

Gemäß einer Weiterbildung der elektronischen Versorgungseinrichtung umfasst die elektrische Platineneinrichtung eine LED-Treibereinrichtung, mit welcher die spezifische elektrische Leistung erkennbar und bereitstellbar ist.

Gemäß einer Weiterbildung der elektronischen Versorgungseinrichtung umfasst die elektrische Platineneinrichtung einen Hot-Plug-Schutz.

Gemäß einer Weiterbildung der elektronischen Versorgungseinrichtung umfasst die elektronische Versorgungseinrichtung eine Signalleuchte, welche an dem Gehäuse angeordnet ist und über welche ein elektrischer Kontakt mit der externen elektrischen Leitereinrichtung anzeigbar ist.

Gemäß einer Weiterbildung der elektronischen Verbrauchereinrichtung umfasst der elektrische Verbraucher ein Gehäuse mit einem Aufsatzbereich, mit welchem der elektrische Verbraucher auf der Oberfläche der externen elektrischen Leitereinrichtung oder auf einer die externe elektrische Leitereinrichtung überdeckende Oberfläche aufsetzbar ist und magnetisch fixierbar ist und in dem Aufsatzbereich eine Kontaktausnehmung aufweist, in welche die elektronische Versorgungseinrichtung einfassbar ist und sich bei eingefasster Versorgungseinrichtung die Gegenkontakte des elektrischen Verbrauchers von dem Gehäuse des elektrischen Verbrauchers bis in die Kontaktausnehmung hinein erstrecken und bei einer Einfassung des elektrischen Verbrauchers die Gegenkontakte mit den jeweilig zugehörigen Außenkontakten der elektronischen Versorgungseinrichtung elektrisch kontaktierbar sind.

Es kann also der elektrische Verbraucher ebenfalls an der gleichen Oberfläche der externen elektrischen Leitereinrichtung angebracht werden, wie die elektronische Versorgungseinrichtung selbst. Dazu kann der elektrische Verbraucher selbst ein Gehäuse mit dem Aufsatzbereich umfassen. Das Gehäuse der elektronischen Versorgungseinrichtung kann in die Kontaktausnehmung eingefasst werden, vorteilhaft von der Kontaktausnehmung und dem Gehäuse des Verbrauchers überdeckt werden. Dabei können die Gegenkontakte an die zugehörigen Außenkontakte angesetzt werden. Dabei können beispielsweise die Gegenkontakte aus einer Ruhestellung in eine Kontaktstellung gedrückt werden, mit anderen Worten entgegen einer Federspannung zum Gehäuse des Verbrauchers hin (in dieses Gehäuse hinein), wenn das Gehäuse des Verbrauchers über das Gehäuse der Versorgungseinrichtung aufgesetzt wird. Beim Entfernen der Gehäuse voneinander kann die Federspannung der einzelnen Gegenkontakte diese wieder in eine Ruhestellung ausfahren. Bei den Gegenkontakten kann es sich beispielsweise um Stiftkontakte handeln, welche an deren Spitzen eine elektrische Kontaktoberfläche aufweisen können, mit welcher der Stiftkontakt eine Elektronik des Verbrauchers in elektrischen Kontakt mit dem zugehörigen Außenkontakt der Versorgungseinrichtung bringen kann. Die Stiftkontakte können abgerundete elektrische Kontaktoberflächen an deren Spitzen aufweisen.

Gemäß einer Weiterbildung der elektronischen Verbrauchereinrichtung sind die Kontaktausnehmung und das Gehäuse des elektrischen Verbrauchers kreisrund und bei Einfassung konzentrisch zueinander orientiert und planar hinsichtlich der Oberfläche beabstandet oder greifen bündig ineinander, wobei das Gehäuse des elektrischen Verbrauchers um 360° um das Gehäuse der elektronischen Versorgungseinrichtung und um die konzentrische Achse drehbar ist.

Gemäß einer Weiterbildung der elektronischen Verbrauchereinrichtung umfassen die Gegenkontakte des elektrischen Verbrauchers gefederte Stiftkontakte.

Gemäß einer Weiterbildung der elektronischen Verbrauchereinrichtung umfasst der elektrische Verbraucher eine dimmbare oder nicht-dimmbare Leuchte.

Gemäß einer Weiterbildung der elektronischen Verbrauchereinrichtung umfasst der elektrische Verbraucher ein Ladegerät oder eine Anzeigevorrichtung oder eine Stromquelle für einen weiteren Verbraucher.

Des Weiteren kann der Verbraucher einfach nur eine Steckerbuchse darstellen, beispielsweise in USB- oder USB-C oder andere Standards. Des Weiteren kann der Verbraucher ein Power-Connector, ein DC-Jack oder eine Lichtquelle oder Anzeigevorrichtung (Display, Bilderrahmen oder ähnliches) oder ein Ladegerät sein.

Durch den Spannungsteiler können vorteilhaft Verbraucher mit unterschiedlichen Spezifikationen von den beiden ersten Außenkontakten mit ihrer spezifischen Leistungsaufnahme versorgt sein. Der Vorteil dabei ist, dass verschiedene Verbraucher mit unterschiedlichen spezifischen Leistungsaufnahmen mit derselben Versorgungseinrichtung betrieben werden können. Benutzer brauchen keine verschiedenen Stecker für verschiedene Verbraucher, sondern können dieselben Stecker beliebig an der Oberfläche positionieren und unterschiedliche Verbraucher daran/darüber befestigen. Dies erhöht vorteilhaft die Freiheit der möglichen Anordnungen und verhindert Beschädigungen der Verbraucher oder reduziert zumindest die Gefahr dazu signifikant. Anstatt der Anwendung von Magneten in dem Gehäuse der Versorgungseinrichtung kann auch nur die Reibung zwischen den Oberflächen und der Nadeln beim Eindringen in die Oberfläche und den Leiter genutzt werden.

In der Wand oder Decke oder dem Aufsatz zur Wand oder Decke können Leiter der Leitereinrichtung als unterschiedlich gepolte elektrische Leiterbahnen (beispielsweise 48V) ausgestaltet sein, wobei die Kontaktnadeln der Leiterkontakteinrichtung in der Kontaktstellung die Befestigungsoberfläche der Leitereinrichtung durchdringen und immer mit mindestens zwei unterschiedlich gepolten Leiterbahnen in elektrischer Verbindung stehen.

Der Gleichrichter kann an einer der zweiten Platine zugewandten Seite der ersten Platine angebracht sein oder umgekehrt. Die Platinenwiderstände können an der ersten Platine angeordnet sein oder an der zweiten.

Ein an der zweiten Platine oder an der ersten Platine angeordneter LED-Driver kann für die Bereitstellung der spezifischen Leistungsaufnahme des Verbrauchers über den ersten und zweiten Außenkontakt sorgen.

Der Verbraucher kann wahlweise als dimmbare oder nicht-dimmbare Leuchte ausgestaltet sein, der vom Platinenbausatz mit seiner spezifischen Leistungsaufnahme versorgt werden kann (wenn dimmbar, dann in jeder wählbaren Dimming-Stufe).

Der Verbraucher kann in der Verbraucherkontaktstellung lösbar und drehbar an der Versorgungseinrichtung oder die Versorgungseinrichtung überlappend an der Befestigungsoberfläche befestigt sein. Mit anderen Worten ist es auch möglich, dass das der elektrische Verbraucher ein Gehäuse mit einem Aufsatzbereich umfasst, mit welchem der elektrische Verbraucher auf dem Gehäuse der Versorgungseinrichtung aufsetzbar ist und magnetisch fixierbar ist und aus dem Aufsatzbereich und einer darin vorhandenen Kontaktausnehmung sich Gegenkontakte des elektrischen Verbrauchers von dem Gehäuse des elektrischen Verbrauchers bis an die jeweilig zugehörigen Außenkontakten der elektronischen Versorgungseinrichtung erstrecken kann.

Eine Signal-LED an der Außenseite der Versorgungseinrichtung, etwa an der ersten Platine angeordnet kann leuchten, wenn eine elektrische Verbindung mit den Leitern besteht.

Als Beispielgrößen kann dem Verbraucher eine Spannung von 3V bei 400 mA mit einem R1 = 400 KiloOhm und R2= 50000 Ohm und R3 = 30000 Ohm gesetzt werden. Bei konstanten R2 und R3 kann unter R1 = 560 kiloOhm ein Strom von 300 mA und eine Spannung am Verbraucher von 2,25 V gesetzt werden. Es sind auch andere Größenordnungen erzielbar, etwa R1 = 1,84 megaOhm bei einem Strom von 100 mA und einer Spannung von 0,75 V. Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### KURZE INHALTSANGABE DER FIGUREN

Die vorliegende Erfindung wird nachfolgend anhand der in den schematischen Figuren angegebenen Ausführungsbeispiele näher erläutert. Es zeigen dabei:
Fig. 1a zeigt eine schematische Darstellung einer elektronischen Versorgungseinrichtung gemäß einem Ausführungsbeispiel der vorliegenden Erfindung.
Fig. 1b zeigt die elektronische Versorgungseinrichtung aus der Fig. 1a schräg von deren Unterseite.
Fig. 2 zeigt eine schematische Darstellung der elektrischen Platineneinrichtung der elektronischen Versorgungseinrichtung gemäß einem Ausführungsbeispiel der vorliegenden Erfindung.
Fig. 3 zeigt eine Draufsicht auf eine zweite Platine der elektrischen Platineneinrichtung.
Fig. 4 zeigt eine schematische Ansicht einer elektronischen Verbrauchereinrichtung gemäß einem Ausführungsbeispiel der vorliegenden Erfindung.
Fig. 5 zeigt eine schematische Schnittdarstellung der elektrischen Platineneinrichtung der elektronischen Versorgungseinrichtung mit zusammengesteckter erster Platine und zweiter Platine.
Fig. 6 zeigt eine schematische Darstellung der elektronischen Verbrauchereinrichtung in einer Außenansicht gemäß einem Ausführungsbeispiel der vorliegenden Erfindung.

Die beiliegenden Figuren sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt. Richtungsangebende Terminologie wie etwa "oben", "unten", "links", "rechts", "über", "unter", "horizontal", "vertikal", "vorne", "hinten" und ähnliche Angaben werden lediglich zu erläuternden Zwecken verwendet und dienen nicht der Beschränkung der Allgemeinheit auf spezifische Ausgestaltungen wie in den Figuren gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

### AUSFÜHRLICHE BESCHREIBUNG VON AUSFÜHRUNGSBEISPIELEN

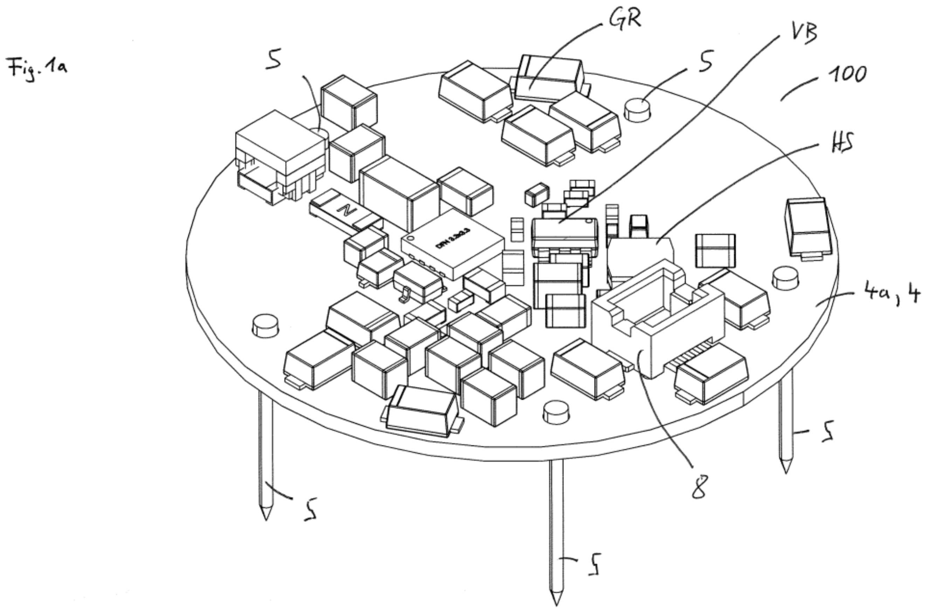

Fig. 1a zeigt eine schematische Darstellung einer elektronischen Versorgungseinrichtung gemäß einem Ausführungsbeispiel der vorliegenden Erfindung.

Die elektronische Versorgungseinrichtung 100 ist in der Fig. 1a mit einer ersten Platine 4a der Platineneinrichtung 4 gezeigt. Auf deren Oberseite sind unterschiedliche Bauelemente der Platineneinrichtung 4 und der Versorgungseinrichtung 100 in schematischer Weise gezeigt. Diese Anordnung kann auch variieren. Die erste Platine 4a ist kreisrund und weist eine Steckerfassung einer Steckereinrichtung 8 auf, etwa als weibliches Gegenstück, welches mit einem entsprechenden Gegenstück an der zweiten Platine (nicht gezeigt) miteinander verbunden werden kann und beide Platinen verschaltet werden können, etwa wenn übereinander angeordnet. An der ersten Platine 4a können Nadeln der Leiterkontakteinrichtung 5 angebracht sein, die sich in eine erste Richtung von der ersten Platine 4a wegerstrecken können. Das Gehäuse der Versorgungseinrichtung wird in der Fig. 1a nicht gezeigt.

Die Fig. 1a zeigt weiterhin beispielhafte Anordnungen von Bauelementen, bei welchen es sich um einen Gleichrichter GR handeln kann, um einen Hot-Plug Schutz HS, um eine Versorgung VB für eine Bluetooth-Übertragung und/oder um weiteres.

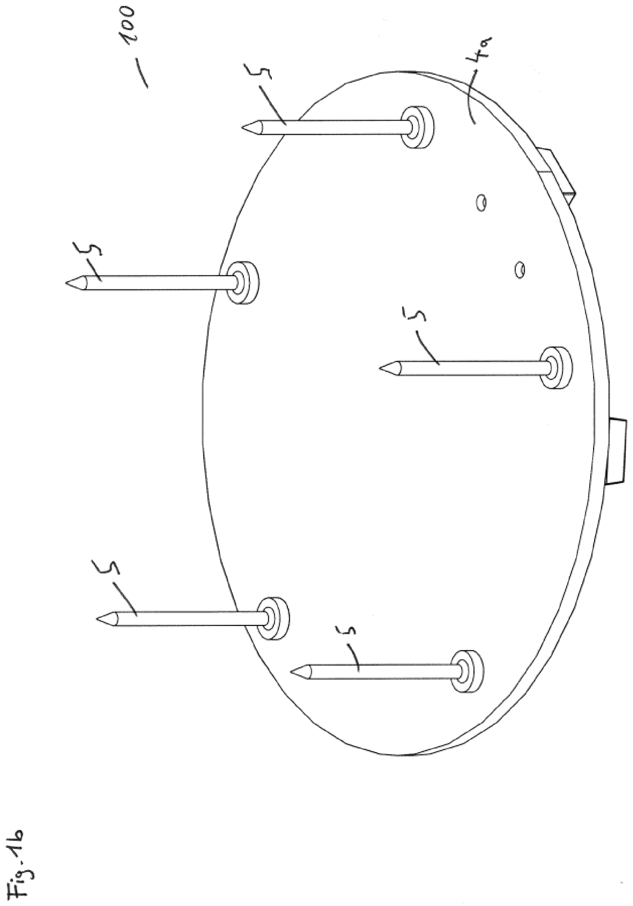

Fig. 1b zeigt die elektronische Versorgungseinrichtung aus der Fig. 1a schräg von deren Unterseite.

Die Nadeln der Leiterkontakteinrichtung 5 können sich senkrecht von der ersten Platine 4a wegerstrecken. In der Kontaktstellung des Gehäuses (nicht gezeigt) der Versorgungseinrichtung 100 können diese Nadeln 5 dann durch Öffnungen im Gehäuse und aus dem Gehäuse herausgeschoben werden.

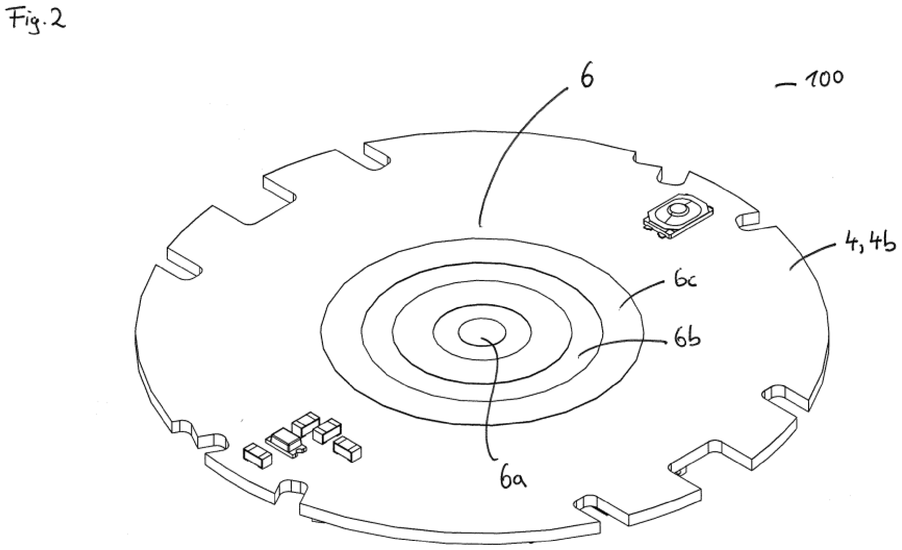

Fig. 2 zeigt eine schematische Darstellung der elektrischen Platineneinrichtung der elektronischen Versorgungseinrichtung gemäß einem Ausführungsbeispiel der vorliegenden Erfindung.

Die Platineneinrichtung 4 kann eine zweite Platine 4b umfassen, welche in der Fig. 2 aus einer zweiten Richtung dargestellt ist, die in deren Anordnung der ersten Richtung aus der Fig. 1a entgegengesetzt ist. Die zweite Platine und damit die Versorgungseinrichtung 100 kann eine elektrische Außenkontakteinrichtung 6 umfassen, welche von Gegenkontakten des elektrischen Verbrauchers (nicht gezeigt) kontaktierbar ist, wobei die elektrische Außenkontakteinrichtung 6 einen ersten Außenkontakt 6a umfasst, welcher mit einem ersten Gegenkontakt (nicht gezeigt) des elektrischen Verbrauchers elektrisch kontaktierbar ist; weiterhin einen zweiten Außenkontakt 6b umfasst, welcher mit einem zweiten Gegenkontakt (nicht gezeigt) des elektrischen Verbrauchers elektrisch kontaktierbar ist; und welcher einen dritten Außenkontakt 6c umfasst, welcher mit einem dritten Gegenkontakt (nicht gezeigt) des elektrischen Verbrauchers elektrisch kontaktierbar ist.

In der Ausführung nach der Fig. 2 können der erste Außenkontakt 6a als eine Kreisfläche gebildet sein und der zweite Außenkontakt 6b und der dritte Außenkontakt 6c als konzentrische und beabstandete Ringflächen den ersten Außenkontakt 6a umlaufen. Die Breite der beiden Ringflächen kann gleich oder verschieden zueinander sein und einer Breite der Gegenkontakte angepasst sein oder vorteilhaft größer als diese sein. Der Mittelpunkt der Kreisfläche kann mit einer Drehachse gleichliegen, um welche ein Gehäuse des Verbrauchers um das Gehäuse der Versorgungseinrichtung gedreht werden kann. Die zweite Platine 4b kann weiterhin am Rand ihrer kreisförmigen Form bestimmte Einkerbungen oder Ausnehmungen zur Fixierung in einem Gehäuse der Versorgungseinrichtung aufweisen.

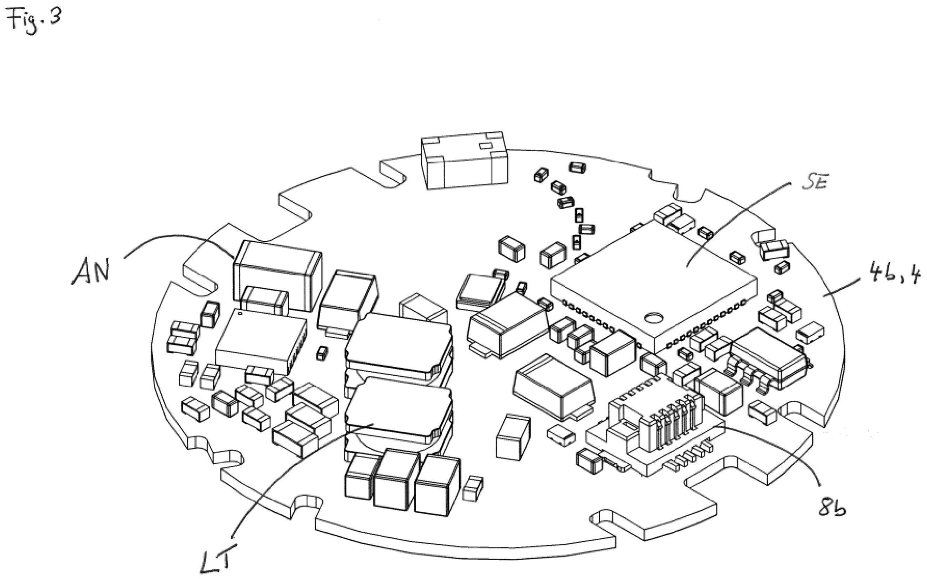

Fig. 3 zeigt eine Draufsicht auf die zweite Platine der elektrischen Platineneinrichtung.

Die Oberseite der zweiten Platine 4b kann gemäß der Ansicht der Fig. 2 mit den dortigen Außenkontakten ausgeformt sein, wobei deren Unterseite weitere elektronische Bauelemente aufweisen kann, wie in Fig. 3 gezeigt, beispielsweise eine Steuereinrichtung SE, mit welcher ein drahtlos übermitteltes Steuerungssignal, beispielsweise bluetooth, empfangbar und interpretierbar ist und über welche ein Betrieb des elektrischen Verbrauchers steuerbar ist. Diese Steuereinrichtung SE und/oder die zweite Platine 4b kann auch eine LED-Treibereinrichtung LT umfassen.

Auf der Unterseite der zweiten Platine 4b ist nun auch das Gegenstück 8b der Steckereinrichtung 8 gezeigt, welches mit dem weiblichen Gegenstück aus der Fig. 1a versteckt werden kann, und über welche ein bestimmter Abstand zwischen beiden Platinen eingestellt werden kann. Für die Drahtlosübertragung kann des Weiteren ein Antennenpfad AN mit zugehörigen Bauteilen realisiert sein.

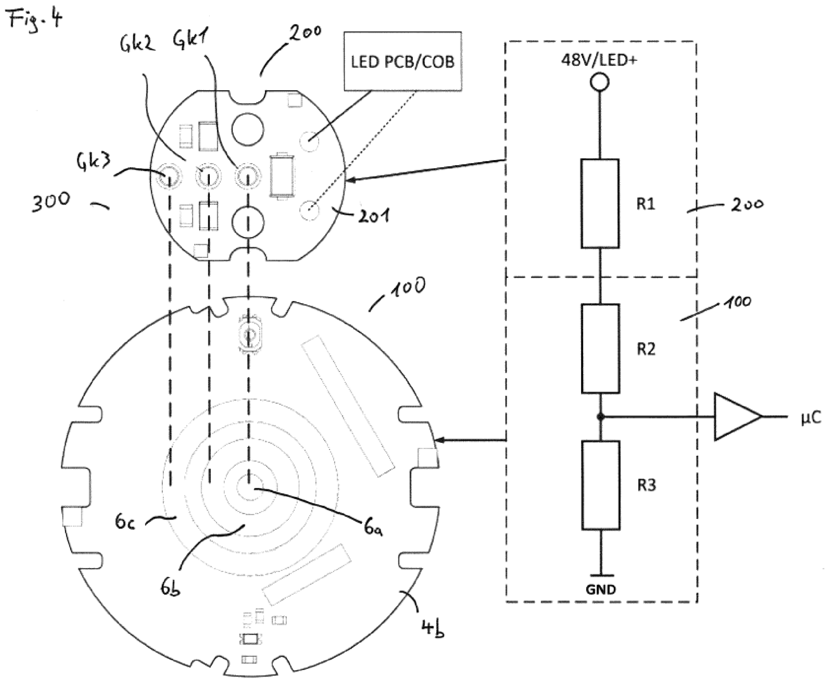

Fig. 4 zeigt eine schematische Ansicht einer elektronischen Verbrauchereinrichtung gemäß einem Ausführungsbeispiel der vorliegenden Erfindung.

Gezeigt wird eine elektronische Verbrauchereinrichtung 300 umfassend eine elektronische Versorgungseinrichtung 100, welche an eine externe elektrische Leitereinrichtung mit einer Oberfläche elektrisch und mechanisch anschließbar ist und die elektronische Verbrauchereinrichtung 300 weiterhin umfassend einen elektrischen Verbraucher 200, welcher über die elektronische Versorgungseinrichtung 100 elektrisch an die externe elektrische Leitereinrichtung anschließbar und betreibbar ist.

Durch einen Gleichrichter können der erste und der zweite Außenkontakt 6a und 6b beispielsweise mit 48V versorgt werden. Wie in dem schematischen Bild rechts dargestellt, kann an den Verbraucher 200, beispielsweise eine LED und an deren Verbraucherwiderstand R1 eine Spannung von 48V angelegt sein. In der Abbildung links wird gezeigt, wie die Gegenkontakte in der Kontaktstellung des Gehäuses der Versorgungseinrichtung mit den zugehörigen Außenkontakten (lateral) positioniert sein können, wobei der dritte Gegenkontakt GK3 mit einem vorbestimmten Verbraucherwiderstand R1 des elektrischen Verbrauchers 200 in elektrischer Verbindung steht, wobei in der Kontaktstellung der vorbestimmte Verbraucherwiderstand R1 mit den Platinenwiderständen R2 und R3 einen Spannungsteiler bilden kann, durch welchen dem elektrischen Verbraucher 200 über den ersten Gegenkontakt GK1 und über den zweiten Gegenkontakt GK2 eine für den jeweiligen elektrischen Verbraucher spezifische elektrische Leistung/Spannung bereitstellbar ist.

Es kann der erste Außenkontakt 6a mit einem ersten Gegenkontakt GK1 des elektrischen Verbrauchers 200 elektrisch kontaktiert sein; und der zweite Außenkontakt 6b mit einem zweiten Gegenkontakt GK2 des elektrischen Verbrauchers 200 elektrisch kontaktiert sein; und der dritte Außenkontakt 6c mit einem dritten Gegenkontakt GK3 des elektrischen Verbrauchers 200 elektrisch kontaktiert sein.

Die beiden Widerstände R2 und R3 der Versorgungseinrichtung 100 können mit einer Erdung GND verbunden sein und zwischen diesen kann eine Steuerung, etwa ein Mikrokontroller µC zur Erzeugung/Aufnahme eines Dimmsignals bei einer dimmbaren Leuchte verschaltet sein (und dabei das Signal vom Spannungsteiler berücksichtigen kann).

Die Verschaltung der Widerstände R2 und R3 kann mit wechselnden Verbrauchern und somit anderen Verbraucherwiderständen R1 nun durch die Anordnung als Spannungsteiler erzielen, dass die an den Verbraucher bereitzustellende Leistung nun zu dessen spezifischer Leistung passen kann, ohne dabei die Versorgungseinrichtung 100 von der Leitereinrichtung abnehmen und tauschen zu müssen. Die Unterschiede in den Leistungen können dabei deutlich sein.

Die Gehäuse von kompatiblen Verbrauchern 200 können alle die gleiche Dimension und Ausgestaltung der Kontaktausnehmung und Gegenkontakte haben. Zur Montage des Gehäuses des Verbrauchers an der Oberfläche der externen elektrischen Leitereinrichtung kann das Gehäuse des Verbrauchers zumindest einen Magnet umfassen, mit welchem das Gehäuse an der Oberfläche der Leitereinrichtung, beispielsweise der Wand oder Decke (eines Raumes), festgehalten werden kann.

Der Verbraucher 200 kann eine LED-Chip-on-board-Einrichtung (COB) umfassen oder eine andere Art von Leuchte, etwa eine LED-PCB.

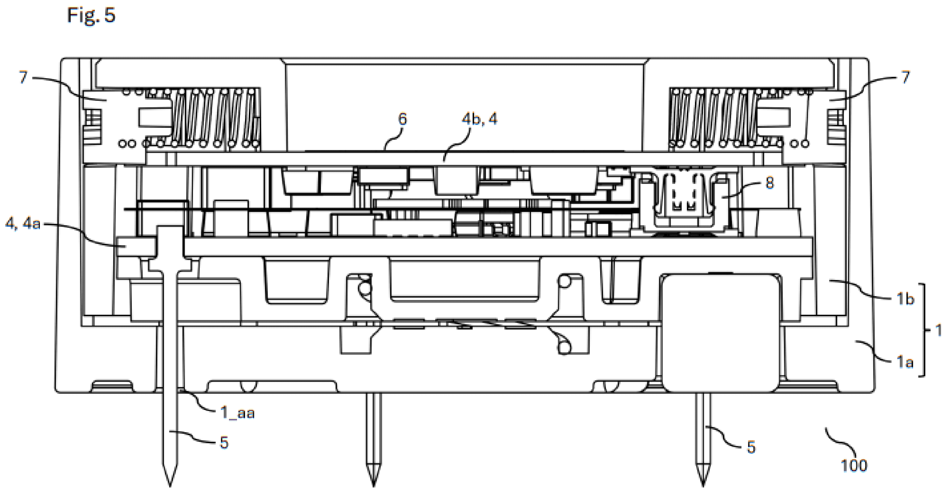

Fig. 5 zeigt eine schematische Schnittdarstellung der elektrischen Platineneinrichtung der elektronischen Versorgungseinrichtung mit zusammengesteckter erster Platine und zweiter Platine.

Die elektronische Versorgungseinrichtung 100 umfasst ein Gehäuse 1 mit einer Befestigungseinrichtung und einer elektrischen Platineneinrichtung 4, wobei das Gehäuse 1 einen ersten Gehäuseteil 1a mit Öffnungen 1aa für die Nadeln der Leiterkontakteinrichtung 5 umfassen kann. Das Gehäuse 1 kann weiterhin einen zweiten Gehäuseteil 1b umfassen, in welchen die Platineneinrichtung 4 mit der ersten Platine 4a und der zweiten Platine 4b eingesteckt sein kann. Die beiden Platinen können mit der Steckereinrichtung 8 miteinander elektrisch und mechanisch verbunden sein. Die Nadeln der Leiterkontakteinrichtung 5 können mit der ersten Platine 4a verbunden und an dieser fest montiert sein und bei Kontaktstellung des Gehäuses 1, wie in der Fig. 5 gezeigt, durch die Öffnungen 1aa des ersten Gehäuseteils 1a geschoben sein. Das zweite Gehäuseteil 1b kann beispielsweise konzentrisch dem ersten Gehäuseteil 1a angeordnet sein und entlang deren Symmetrieachse in einen Innenbereich des ersten Gehäuseteils 1a hineingeschoben werden. Dies kann vorteilhaft nur dann erfolgen, wenn der Sicherheitsmechanismus mit den zugehörigen gefederten Knöpfen 7 gelöst ist, also die beiden Knöpfe 7 in eine laterale Innenposition des zweiten Gehäuseteils 1b geschoben werden, wie in der Fig. 5 dargestellt, und dabei den lateralen Außenrand des ersten Gehäuseteils 1a nicht überragen oder überdecken. Wenn das Gehäuse 1 wieder von der Oberfläche der elektrischen Leitereinrichtung (nicht gezeigt) entfernt wird, werden die Nadeln nicht mehr in dem Material der Leitereinrichtung oder dessen Oberfläche festgehalten und eine Feder kann die beiden Gehäuseteile wieder auseinanderdrücken und die Knöpfe 7 können in Transportstellung des Gehäuses 1 (nicht gezeigt) in die offene Position lateral herausspringen.

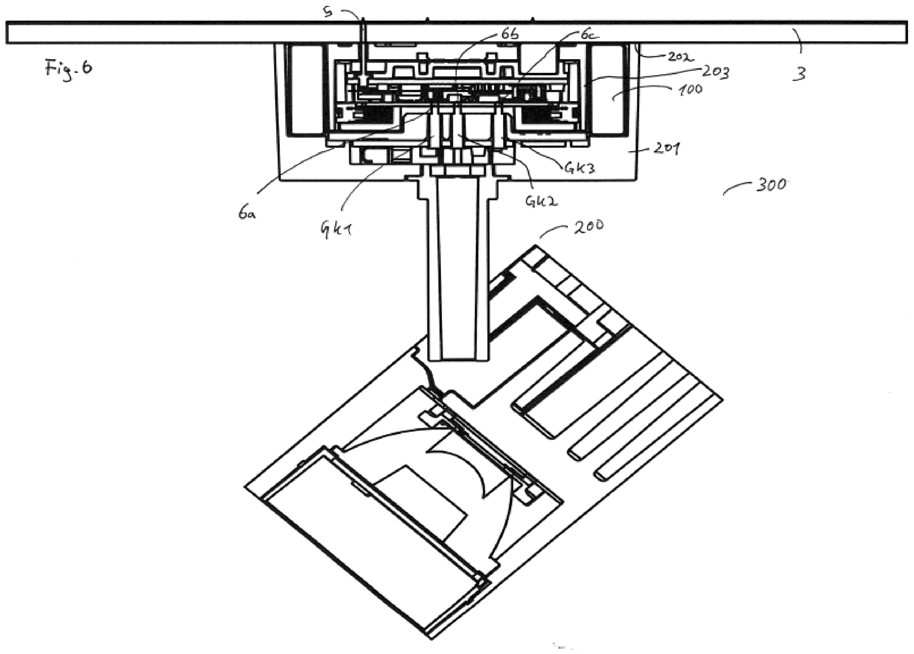

Fig. 6 zeigt eine schematische Darstellung der elektronischen Verbrauchereinrichtung in einer Außenansicht gemäß einem Ausführungsbeispiel der vorliegenden Erfindung.

Die elektronische Verbrauchereinrichtung 300 umfasst eine elektronische Versorgungseinrichtung 100, welche an eine externe elektrische Leitereinrichtung 3 mit einer Oberfläche elektrisch und mechanisch anschließbar ist, wobei die elektronische Verbrauchereinrichtung 300 weiterhin einen elektrischen Verbraucher 200 umfasst, welcher über die elektronische Versorgungseinrichtung 100 elektrisch an die externe elektrische Leitereinrichtung 3 anschließbar und betreibbar ist.

Der elektrische Verbraucher 200 kann ein Gehäuse 201 mit einem Aufsatzbereich 202 umfassen, mit welchem der elektrische Verbraucher 200 auf der Oberfläche der externen elektrischen Leitereinrichtung 3 oder auf einer die externe elektrische Leitereinrichtung 3 überdeckende Oberfläche aufsetzbar ist und magnetisch fixierbar ist und in dem Aufsatzbereich 202 eine Kontaktausnehmung 203 aufweist, in welche die elektronische Versorgungseinrichtung 100 einfassbar ist und sich Gegenkontakte GK1, GK2, GK3 des elektrischen Verbrauchers 200 von dem Gehäuse 201 des elektrischen Verbrauchers 200 bis in die Kontaktausnehmung 203 hinein erstrecken und bei einer Einfassung des elektrischen Verbrauchers 200 die Gegenkontakte mit den jeweilig zugehörigen Außenkontakten 6a, 6b, 6c der elektronischen Versorgungseinrichtung 100 elektrisch kontaktierbar sind.

Die Kontaktausnehmung 203 und das Gehäuse 1 des elektrischen Verbrauchers 200 können kreisrund sein und bei Einfassung konzentrisch zueinander orientiert sein und planar (lateral) hinsichtlich der Oberfläche beabstandet sein oder bündig abschließen, wobei das Gehäuse 201 des elektrischen Verbrauchers 200 um 360° um das Gehäuse 1 der elektronischen Versorgungseinrichtung 100 und um die konzentrische Achse beider Gehäuse drehbar sein kann.

In der vorangegangenen detaillierten Beschreibung sind verschiedene Merkmale zur Verbesserung der Stringenz der Darstellung in einem oder mehreren Beispielen zusammengefasst worden. Es sollte dabei jedoch klar sein, dass die obige Beschreibung lediglich illustrativer, keinesfalls jedoch beschränkender Natur ist. Sie dient der Abdeckung aller Alternativen, Modifikationen und Äquivalente der verschiedenen Merkmale und Ausführungsbeispiele. Viele andere Beispiele werden dem Fachmann aufgrund seiner fachlichen Kenntnisse in Anbetracht der obigen Beschreibung sofort und unmittelbar klar sein.

Die Ausführungsbeispiele wurden ausgewählt und beschrieben, um die der Erfindung zugrundeliegenden Prinzipien und ihre Anwendungsmöglichkeiten in der Praxis bestmöglich darstellen zu können. Dadurch können Fachleute die Erfindung und ihre verschiedenen Ausführungsbeispiele in Bezug auf den beabsichtigten Einsatzzweck optimal modifizieren und nutzen. In den Ansprüchen sowie der Beschreibung werden die Begriffe "beinhaltend" und "aufweisend" als neutralsprachliche Begrifflichkeiten für die entsprechenden Begriffe "umfassend" verwendet. Weiterhin soll eine Verwendung der Begriffe "ein", "einer" und "eine" eine Mehrzahl derartig beschriebener Merkmale und Komponenten nicht grundsätzlich ausschließen.

### BEZUGSZEICHENLISTE

- 1: Gehäuse
- 1a: erstes Gehäuseteil
- 1aa: Öffnung
- 1b: zweites Gehäuseteil
- 100: elektronische Versorgungseinrichtung
- 200: elektrischer Verbraucher
- 201: Gehäuse
- 202: Aufsatzbereich
- 203: Kontaktausnehmung
- 3: externe elektrische Leitereinrichtung
- 300: elektronische Verbrauchereinrichtung
- 4: Platineneinrichtung
- 4a: erste Platine
- 4b: zweite Platine
- 5: Leiterkontakteinrichtung
- 6: elektrische Außenkontakteinrichtung
- 6a: erster Außenkontakt
- 6b: zweiter Außenkontakt
- 6c: dritter Außenkontakt
- 7: Knopf / Sicherheitsmechanismus
- 8, 8b: Steckereinrichtung
- AN: Antennenpfad
- GK1: erster Gegenkontakt
- GK2: zweiter Gegenkontakt
- GK3: dritter Gegenkontakt
- GR: Gleichrichter
- HS: Hot-Plug-Schutz
- LT: LED-Treibereinrichtung
- R1: Verbraucherwiderstand
- R2, R3: Platinenwiderstand
- SE: Steuereinrichtung
- VB: Versorgung Bluetooth

## Patentansprüche

1. Elektronische Versorgungseinrichtung (100) zum elektrischen Anschließen eines elektrischen Verbrauchers (200), umfassend
- ein Gehäuse (1) mit einer Befestigungseinrichtung und einer elektrischen Platineneinrichtung (4), wobei das Gehäuse (1) mittels der Befestigungseinrichtung an einer Oberfläche einer externen elektrischen Leitereinrichtung (3) oder an einer eine externe elektrische Leitereinrichtung überdeckenden Oberfläche in einer Kontaktstellung des Gehäuses mechanisch montierbar ist und die elektrische Platineneinrichtung (4) mittels einer Leiterkontakteinrichtung (5), welche beweglich im und/oder mit dem Gehäuse (1) angeordnet ist, in der Kontaktstellung elektrisch an der externen elektrischen Leitereinrichtung (3) anschließbar ist, wobei die elektrische Platineneinrichtung (4) zumindest einen Platinenwiderstand (R2, R3) umfasst;
- eine elektrische Außenkontakteinrichtung (6), welche an dem Gehäuse (1) angeordnet ist und welche von Gegenkontakten des elektrischen Verbrauchers (200) kontaktierbar ist, wobei die elektrische Außenkontakteinrichtung (6) weiterhin umfasst:
- einen ersten Außenkontakt (6a), welcher mit einem ersten Gegenkontakt (GK1) des elektrischen Verbrauchers (200) elektrisch kontaktierbar ist;
- einen zweiten Außenkontakt (6b), welcher mit einem zweiten Gegenkontakt (GK2) des elektrischen Verbrauchers (200) elektrisch kontaktierbar ist; und
- einen dritten Außenkontakt (6c), welcher mit einem dritten Gegenkontakt (GK3) des elektrischen Verbrauchers (200) elektrisch kontaktierbar ist, wobei der dritte Gegenkontakt (GK3) mit einem vorbestimmten Verbraucherwiderstand (R1) des elektrischen Verbrauchers (200) in elektrischer Verbindung steht, wobei in der Kontaktstellung der vorbestimmte Verbraucherwiderstand (R1) mit dem zumindest einen Platinenwiderstand (R2, R3) einen Spannungsteiler bildet, durch welchen dem elektrischen Verbraucher (200) über den ersten Gegenkontakt (GK1) und über den zweiten Gegenkontakt (GK2) eine für den jeweiligen elektrischen Verbraucher (200) spezifische elektrische Leistung bereitstellbar ist.

2. Elektronische Versorgungseinrichtung (100) nach Anspruch 1,
**dadurch gekennzeichnet, dass** der erste Außenkontakt (6a) und/oder der zweite Außenkontakt (6b) und/oder der dritte Außenkontakt (6c) als Ringkontakt ausgeformt ist/sind.

3. Elektronische Versorgungseinrichtung (100) nach Anspruch 2,
**dadurch gekennzeichnet, dass** der erste Außenkontakt (6a) eine Kreisfläche bildet und der zweite Außenkontakt (6b) und der dritte Außenkontakt (6c) als konzentrische und beabstandete Ringflächen den ersten Außenkontakt (6a) umlaufen.

4. Elektronische Versorgungseinrichtung (100) nach einem der vorhergehenden Ansprüche,
**dadurch gekennzeichnet, dass** die Leiterkontakteinrichtung (5) zumindest zwei Nadeln als elektrische Kontakte umfasst, welche in der Kontaktstellung des Gehäuses (1) aus diesem ausgefahren sind und mit der Oberfläche der externen elektrischen Leitereinrichtung (3) oder mit der die externe elektrische Leitereinrichtung überdeckenden Oberfläche in mechanischen und elektrischen Kontakt bringbar sind.

5. Elektronische Versorgungseinrichtung (100) nach Anspruch 4,
**dadurch gekennzeichnet, dass** mit den Nadeln die Oberfläche der externen elektrischen Leitereinrichtung (3) oder die die externe elektrische Leitereinrichtung überdeckende Oberfläche durchdringbar ist und dabei unterschiedliche Nadeln mit elektrischen Leitern unterschiedlicher Polung kontaktierbar sind.

6. Elektronische Versorgungseinrichtung (100) nach einem der vorhergehenden Ansprüche,
**dadurch gekennzeichnet, dass** die elektrische Außenkontakteinrichtung (6) an einer von außen zugänglichen Oberseite des Gehäuses (1) angeordnet ist, welche einer Unterseite des Gehäuses (1) gegenüberliegt, wobei an der Unterseite die Befestigungseinrichtung angeordnet ist und/oder die Leiterkontakteinrichtung (5) ausfahrbar ist und/oder dass das Gehäuse (1) mit der Befestigungseinrichtung dazu eingerichtet ist, an einer ebenen Oberfläche angeordnet zu werden, welche die externe elektrische Leitereinrichtung (3) darstellt oder diese überdeckt und/oder dass die elektronische Versorgungseinrichtung (100) eine Signalleuchte umfasst, welche an dem Gehäuse (1) angeordnet ist und über welche ein elektrischer Kontakt mit der externen elektrischen Leitereinrichtung (3) anzeigbar ist.

7. Elektronische Versorgungseinrichtung (100) nach einem der vorhergehenden Ansprüche,
**dadurch gekennzeichnet, dass** die elektronische Versorgungseinrichtung (100) und die Platineneinrichtung (4) einen Gleichrichter (GR) umfasst, mit welchem ein über die Leiterkontakteinrichtung (5) von der externen elektrischen Leitereinrichtung (3) aufgenommener Strom auf den ersten Außenkontakt (6a) und den zweiten Außenkontakt (6b) mit zueinander unterschiedlichen Polungen beaufschlagbar ist.

8. Elektronische Versorgungseinrichtung (100) nach einem der vorhergehenden Ansprüche,
**dadurch gekennzeichnet, dass** die elektrische Platineneinrichtung (4) zumindest zwei flache Platinen umfasst, welche zueinander beabstandet und entlang einer Achse zentriert und parallel verlaufen und über eine Kontakteinrichtung oder Steckereinrichtung (8) miteinander verbunden sind.

9. Elektronische Versorgungseinrichtung (100) nach Anspruch 8,
**dadurch gekennzeichnet, dass** die drei Außenkontakte (6a, 6b, 6c) an einer der ersten Platine abgewandten Seite der zweiten Platine angeordnet sind.

10. Elektronische Versorgungseinrichtung (100) nach einem der vorhergehenden Ansprüche,
**dadurch gekennzeichnet, dass** die elektrische Platineneinrichtung (4) eine Steuereinrichtung (SE) umfasst, mit welcher ein drahtlos übermitteltes Steuerungssignal empfangbar und interpretierbar ist und über welche ein Betrieb des elektrischen Verbrauchers (200) steuerbar ist und/oder dass die elektrische Platineneinrichtung (4) eine LED-Treibereinrichtung (LT) umfasst, mit welcher die spezifische elektrische Leistung erkennbar und bereitstellbar ist und/oder dass die elektrische Platineneinrichtung (4) einen Hot-Plug-Schutz (HS) umfasst und/oder dass der Platinenwiderstand (R2, R3) einen ersten Widerstand (R2) und einen zweiten Widerstand (R3) umfasst, welche in Kontaktstellung mit dem vorbestimmten Verbraucherwiderstand (R1) einen Spannungsteiler bilden.

11. Elektronische Versorgungseinrichtung (100) nach Anspruch 9, soweit rückbezogen auf Anspruch 7, wobei der Gleichrichter (GR) an einer der zweiten Platine zugewandten Seite der ersten Platine angeordnet ist.

12. Elektronische Verbrauchereinrichtung (300) umfassend eine elektronische Versorgungseinrichtung (100) nach einem der vorhergehenden Ansprüche 1 bis 11, welche an eine externe elektrische Leitereinrichtung (3) mit einer Oberfläche elektrisch und mechanisch anschließbar ist und die elektronische Verbrauchereinrichtung (300) weiterhin umfassend einen elektrischen Verbraucher (200), welcher über die elektronische Versorgungseinrichtung (100) elektrisch an die externe elektrische Leitereinrichtung (3) anschließbar und betreibbar ist.

13. Elektronische Verbrauchereinrichtung (300) nach Anspruch 12,
**dadurch gekennzeichnet, dass** der elektrische Verbraucher (200) ein Gehäuse (201) mit einem Aufsatzbereich (202) umfasst, mit welchem der elektrische Verbraucher (200) auf der Oberfläche der externen elektrischen Leitereinrichtung (3) oder auf einer die externe elektrische Leitereinrichtung (3) überdeckende Oberfläche aufsetzbar ist und magnetisch fixierbar ist und in dem Aufsatzbereich (202) eine Kontaktausnehmung (203) aufweist, in welche die elektronische Versorgungseinrichtung (100) einfassbar ist und sich Gegenkontakte (GK1, GK2, GK3) des elektrischen Verbrauchers (200) von dem Gehäuse (201) des elektrischen Verbrauchers (200) bis in die Kontaktausnehmung (203) hinein erstrecken und bei einer Einfassung des elektrischen Verbrauchers (200) die Gegenkontakte mit den jeweilig zugehörigen Außenkontakten (6a, 6b, 6c) der elektronischen Versorgungseinrichtung (100) elektrisch kontaktierbar sind.

14. Elektronische Verbrauchereinrichtung (300) nach Anspruch 13,
**dadurch gekennzeichnet, dass** die Kontaktausnehmung (203) und das Gehäuse (1) des elektrischen Verbrauchers (200) kreisrund sind und bei Einfassung konzentrisch zueinander orientiert sind und planar hinsichtlich der Oberfläche beabstandet sind, wobei das Gehäuse (201) des elektrischen Verbrauchers (200) um 360° um das Gehäuse (1) der elektronischen Versorgungseinrichtung (100) und um die konzentrische Achse drehbar ist und/oder dass die Gegenkontakte (GK1, GK2, GK3) des elektrischen Verbrauchers (200) gefederte Stiftkontakte umfassen.

15. Elektronische Verbrauchereinrichtung (300) nach einem der Ansprüche 12 bis 14, **dadurch gekennzeichnet, dass** der elektrische Verbraucher (200) eine dimmbare oder nicht-dimmbare Leuchte umfasst und/oder dass der elektrische Verbraucher (200) ein Ladegerät oder eine Anzeigevorrichtung oder eine Stromquelle für einen weiteren Verbraucher umfasst.
